(19) Europäisches Patentamt

European Patent Office

Office européen des brevets

(11) **EP 1 114 325 B1**

(12) **EUROPÄISCHE PATENTSCHRIFT**

(45) Veröffentlichungstag und Bekanntmachung des Hinweises auf die Patenterteilung:
**13.03.2002 Patentblatt 2002/11**

(21) Anmeldenummer: **00902600.6**

(22) Anmeldetag: **17.01.2000**

(51) Int Cl.7: **G01R 15/24**, G01R 15/20

(86) Internationale Anmeldenummer:
**PCT/EP00/00316**

(87) Internationale Veröffentlichungsnummer:
**WO 00/54063 (14.09.2000 Gazette 2000/37)**

(54) **VORRICHTUNG UND VERFAHREN ZUR STROMMESSUNG**

DEVICE AND METHOD FOR MEASURING AN ELECTRIC CURRENT

DISPOSITIF ET PROCEDE DE MESURE DE l'INTENSITE D'UN COURANT ELECTRIQUE

(84) Benannte Vertragsstaaten:
**AT BE CH CY DE DK ES FI FR GB GR IE IT LI LU MC NL PT SE**

(30) Priorität: **11.03.1999 DE 19910801**

(43) Veröffentlichungstag der Anmeldung:
**11.07.2001 Patentblatt 2001/28**

(73) Patentinhaber: **Fraunhofer-Gesellschaft zur Förderung der angewandten Forschung e.V. 80636 München (DE)**

(72) Erfinder:
• **HOHE, Hans-Peter**
  **D-91332 Heiligenstadt (DE)**
• **WEBER, Norbert**
  **D-91367 Weissenohe (DE)**
• **SAUERER, Josef**
  **D-91074 Herzogenaurach (DE)**

(74) Vertreter: **Schoppe, Fritz, Dipl.-Ing. Patentanwälte Schoppe, Zimmermann, Stöckeler & Zinkler, Postfach 71 08 67 81458 München (DE)**

(56) Entgegenhaltungen:
**US-A- 5 017 804        US-A- 5 438 256**

EP 1 114 325 B1

**Beschreibung**

Die vorliegende Erfindung betrifft eine Vorrichtung und ein Verfahren zur Strommessung und insbesondere eine Vorrichtung und ein Verfahren zum Messen des Stroms durch einen oder mehrere Leiter einer Anordnung von mehreren in unmittelbarer räumlicher Nähe angeordneten Stromleitern.

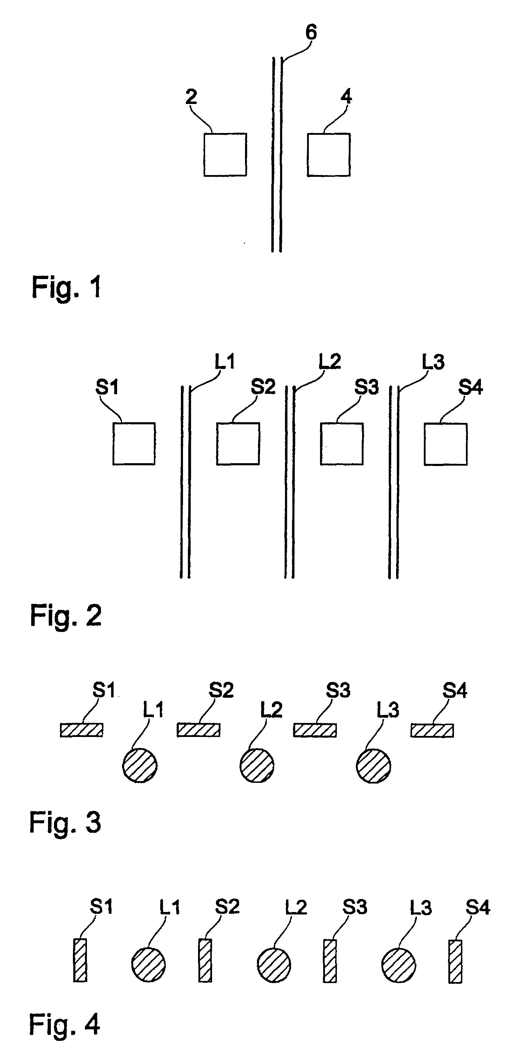

Zur potentialfreien Strommessung ist es bekannt, zwei magnetfeldempfindliche Sensoren auf beiden Seiten eines Stromleiters zu plazieren. Eine solche Anordnung ist schematisch in Fig. 1 dargestellt, wo zwei magnetfeldempfindliche Sensoren 2 und 4 auf beiden Seiten eines Stromleiters 6 angeordnet sind. Durch die magnetfeldempfindlichen Sensoren 2 und 4 wird das, von einem den Leiter 6 durchfließenden Strom verursachte Magnetfeld gemessen. Durch eine Differenzbildung der Ausgangssignale der beiden magnetfeldempfindlichen Sensoren 2 und 4 wird der Strom im Leiter ermittelt, wobei durch dieses Prinzip ein vorhandenes, gradientenfreies Magnetfeld bei der Strommessung eliminiert werden kann. Nachteilig bei der oben beschriebenen Anordnung ist, daß 2n Sensoren erforderlich sind, wenn man den Strom in n Leitern gleichzeitig messen will. Überdies ist das bekannte Verfahren problematisch, wenn der Strom durch mehrere Leiter gemessen werden soll und die Leiter nahe beieinander liegen. In diesem Fall entsteht am Ort eines Leiters ein Magnetfeldgradient aufgrund des Stromes eines Nachbarleiters, so daß die Strommessung gestört ist. Der Einfluß des Magnetfeldgradienten aufgrund des Stromes im Nachbarleiter kann nicht kompensiert werden.

Die Aufgabe der vorliegenden Erfindung besteht darin, eine Vorrichtung und ein Verfahren zum Messen des Stroms durch einen oder mehrere Leiter einer Anordnung von n Leitern unter Verwendung einer reduzierten Anzahl von magnetfeldempfindlichen Sensoren zu schaffen, die ferner die exakte Erfassung des Stroms durch einen der Leiter ermöglichen, auch wenn die einzelnen Leiter der Leiteranordnung in unmittelbarer räumlicher Nähe angeordnet sind.

Diese Aufgabe wird durch eine Strommeßvorrichtung gemäß Anspruch 1 und ein Verfahren gemäß Anspruch 8 gelöst.

Die vorliegende Erfindung schafft eine Strommeßvorrichtung zum Messen des Stroms durch einen oder mehrere Leiter einer Anordnung von n Leitern, wobei n eine natürliche Zahl ≥ 2 ist, bei der n+1 magnetfeldempfindliche Sensoren derart angeordnet sind, daß jeweils zwei magnetfeldempfindliche Sensoren benachbart zu einem jeweiligen Leiter angeordnet sind. Ferner ist eine Einrichtung zum Auslesen von Ausgangssignalen der magnetfeldempfindlichen Sensoren vorgesehen. Schließlich weist die Strommeßvorrichtung eine Einrichtung zum Berechnen des Stroms durch einen oder mehrere der Leiter auf der Grundlage der ausgelesenen Ausgangssignale und von Koeffizienten, die den Einfluß von Strömen durch jeden der n Leiter und eines magnetischen Gleichfelds auf das Ausgangssignal eines jeden der magentfeldempfindlichen Sensoren beschreiben, auf.

Die vorliegende Erfindung ermöglicht somit eine Reduzierung der benötigten magnetfeldempfindlichen Sensoren von 2n auf n+1, wenn der Strom durch n Leiter erfaßt werden soll. Überdies ermöglicht die vorliegende Erfindung die Kompensation von Einflüssen, die durch in der Nähe angeordnete, stromdurchflossene Leiter bewirkt werden, auf die Strommessung in einem Leiter. Somit liefert die vorliegende Erfindung zum einen eine wenige aufwendige Strommeßvorrichtung, die zum anderen exakte Ergebnisse bei in unmittelbarer räumlicher Nähe angeordneten Stromleitern liefert.

Bei den magnetfeldempfindlichen Sensoren handelt es sich vorzugsweise um Hallsensoren, die zusammen mit der Auswerteelektronik, d.h. der Einrichtung zum Auslesen und der Einrichtung zum Berechnen, sowie vorzugsweise einem Speicher zum Speichern der Koeffizienten, monolithisch auf einem Halbleitersubstrat gefertigt sind.

Die vorliegende Erfindung schafft ferner ein Verfahren zum Messen des Stroms durch einen oder mehrere Leiter einer Anordnung von n Leitern, wobei n eine natürliche Zahl ≥ 2 ist, bei dem zunächst die Ausgangssignale von n+1 magnetfeldempfindlichen Sensoren, von denen jeweils zwei benachbart zu einem jeweiligen Leiter angeordnet sind, ausgelesen werden. Nachfolgend wird der Strom durch einen oder mehrere der Leiter auf der Grundlage der ausgelesenen Ausgangssignale und von Koeffizienten, die den Einfluß von Strömen durch jeden der n Leiter und eines magnetischen Gleichfelds auf das Ausgangssignal eines jeden der magnetfeldempfindlichen Sensoren beschreiben, berechnet.

Bevorzugte Ausführungsbeispiele des erfindungsgemäßen Verfahrens umfassen ferner den Schritt des Durchführens einer Kalibriermessung, um die Koeffizienten zu berechnen. Dabei werden die Koeffizienten als Matrixkoeffizienten derart ermittelt, daß abwechselnd durch jeden Leiter ein definierte Strom geführt wird, während die anderen Leiter keinen Strom führen. Überdies wird eine weitere Kalibriermessung durchgeführt, bei der die magnetfeldempfindlichen Sensoren mit einem Gleichmagnetfeld, d.h. einem gradientenfreien Magnetfeld bekannter Größe, beaufschlagt werden, während kein Strom durch die Leiter fließt. Zur Berechnung des Stroms durch einen oder mehrere der Leiter werden dann die Sensorsignale von allen magnetfeldempfindlichen Sensoren über eine Matrixoperation unter Verwendung der ermittelten Koeffizientenmatrix linear miteinander verknüpft.

Wie oben genannt wurde, sind die magnetfeldempfindlichen Sensoren vorzugsweise Hallsensoren. Diese Hallsensoren sind auf senkrecht auftreffende Magnetfelder empfindlich, so daß die Sensoren zwischen den Leitern oder in dem Leiterzwischenraum nach oben oder unten versetzt angeordnet sind.

Daneben können erfindungsgemäß auch Sensoren verwendet werden, die auf parallel zur Oberfläche auftreffende Magnetfelder empfindlich sind, beispielsweise Feldplatten. Diese Sensoren werden in einer solchen Beziehung zu den Leitern angeordnet, daß das von den Leitern erzeugte Magnetfeld im wesentlichen parallel zur Oberfläche auf die Sensoren auftrifft.

Bevorzugte Ausführungsbeispiele der vorliegenden Erfindung werden nachfolgend bezugnehmend auf die beiliegenden Zeichnungen näher erläutert. Es zeigen:

Fig. 1    schematisch eine bekannte Strommeßanordnung;

Fig. 2    schematisch eine Strommeßanordnung gemäß der vorliegenden Erfindung;

Fig. 3    schematisch eine alternative Anordnung von Hallsensoren zur Strommessung gemäß der vorliegenden Erfindung;

Fig. 4    eine Anordnung von Feldplatten zur Strommessung gemäß der vorliegenden Erfindung; und

Fig. 5    eine schematische Darstellung der erfindungsgemäßen Strommeßvorrichtung.

Fig. 2 zeigt schematisch die erfindungsgemäße Anordnung magnetfeldempfindlicher Sensoren zur Messung des Stroms in drei in unmittelbarer räumlicher Nähe angeordneten Leitern L1, L2, L3. Wie in Fig. 2 gezeigt ist, sind zur Messung der Ströme in den Leitern L1, L2, L3 lediglich vier magnetfeldempfindliche Sensoren S1, S2, S3 und S4 erforderlich. Die vier Sensoren sind dabei derart angeordnet, daß jeweils zwei magnetfeldempfindliche Sensoren, z. B. S1 und S2, benachbart zu einem jeweiligen Leiter, z.B. L1, angeordnet sind. Zur Erfassung des Stroms durch einen der Leiter werden nun die Ausgangssignale aller magnetfeldempfindlicher Sensoren S1 bis S4 über eine Matrixoperation linear miteinander verknüpft, wobei die Matrixkoeffizienten über eine Kalibriermessung ermittelt werden, derart, daß abwechselnd durch jeden Leiter ein definierter Strom geführt wird, während die anderen Leiter keinen Strom führen.

Ferner wird eine Kalibriermessung durchgeführt, bei der die Anordnung mit einem bekannten Gleichmagnetfeld beaufschlagt ist, während kein Strom durch die Leiter fließt.

Die sich ergebende Koeffizientenmatrix lautet:

$$\begin{bmatrix} a_{11} & a_{12} & a_{13} & a_{14} \\ a_{21} & a_{22} & a_{23} & a_{24} \\ a_{31} & a_{32} & a_{33} & a_{34} \\ a_{g1} & a_{g2} & a_{g3} & a_{g4} \end{bmatrix}$$

Dabei werden die Koeffizienten $a_{11}$ bis $a_{14}$ erhalten, während nur der Leiter L1 von einem bekannten Strom durchflossen ist, die Koeffizienten $a_{21}$ bis $a_{24}$ werden erhalten, während nur der Leiter L2 von einem bekannten Strom durchflossen ist, und die Koeffizienten $a_{31}$ bis $a_{34}$ werden erhalten, während nur der Leiter L3 von einem bekannten Strom durchflossen ist. Die Koeffizienten $a_{g1}$ bis $a_{g4}$ werden erhalten, während ein bekanntes Gleichmagnetfeld anliegt und keiner der Leiter von einem Strom durchflossen ist.

Die erste Zahl des Index eines jeweiligen Koeffizienten bezeichnet jeweils einen Leiter, während die zweite Zahl im Index jeweils einen Sensor bezeichnet, so daß beispielsweise der Koeffizient $a_{11}$ den Einfluß eines Stroms durch den Leiter L1 auf das Ausgangssignal des Sensors S1 beschreibt. Im Falle der Koeffizienten $a_{g1}$ bis $a_{g4}$ steht der Buchstabe g jeweils für das magnetische Gleichfeld, so daß diese Koeffizienten den Einfluß eines magnetischen Gleichfelds auf das Ausgangssignal eines jeweiligen Sensors beschreibt.

Unter Verwendung der obigen Koeffizienten setzen sich die Ausgangssignale $A_1$ bis $A_4$ der vier magnetfeldempfindlichen Sensoren S1 bis S4 wie folgt zusammen:

$$A_1 = a_{11} \cdot I_1 + a_{21} \cdot I_2 + a_{31} \cdot I_3 + a_{g1} \cdot Hg$$

$$A_2 = a_{12} \cdot I_1 + a_{22} \cdot I_2 + a_{32} \cdot I_3 + a_{g2} \cdot Hg$$

$$A_3 = a_{13} \cdot I_1 + a_{23} \cdot I_2 + a_{33} \cdot I_3 + a_{g3} \cdot Hg$$

$$A_4 = a_{14} \cdot I_1 + a_{24} \cdot I_2 + a_{34} \cdot I_3 + a_{g4} \cdot Hg$$

wobei $I_1$ einen Strom durch den Leiter L1, $I_2$ einen Strom durch den Leiter L2, $I_3$ einen Strom durch den Leiter L3 und Hg ein anliegendes magnetisches Gleichfeld darstellen.

Die obigen Gleichungen können in Matrix- bzw. Vektorform wie folgt dargestellt werden:

$$
\begin{bmatrix} A_1 \\ A_2 \\ A_3 \\ A_4 \end{bmatrix}
=
\begin{bmatrix}
a_{11} & a_{12} & a_{13} & a_{14} \\
a_{21} & a_{22} & a_{23} & a_{24} \\
a_{31} & a_{32} & a_{33} & a_{34} \\
a_{g1} & a_{g2} & a_{g3} & a_{g4}
\end{bmatrix}
\cdot
\begin{bmatrix} I_1 \\ I_2 \\ I_3 \\ Hg \end{bmatrix}
$$

Somit können die einzelnen, die Leiter L1 bis L3 durchfließenden Ströme $I_1$ bis $I_3$ nach einer Invertierung der Koeffizientenmatrix wie folgt berechnet werden:

$$
\begin{bmatrix} I_1 \\ I_2 \\ I_3 \\ Hg \end{bmatrix}
=
\begin{bmatrix}
a_{11} & a_{12} & a_{13} & a_{14} \\
a_{21} & a_{22} & a_{23} & a_{24} \\
a_{31} & a_{32} & a_{33} & a_{34} \\
a_{g1} & a_{g2} & a_{g3} & a_{g4}
\end{bmatrix}^{-1}
\cdot
\begin{bmatrix} A_1 \\ A_2 \\ A_3 \\ A_4 \end{bmatrix}
$$

Auf diese Weise kann erfindungsgemäß der Strom durch jeden der Stromleiter L1 bis L3 exakt berechnet werden, wobei nur n-1 magnetfeldempfindliche Sensoren benötigt werden, wenn der Strom durch n Leiter gemessen werden soll. Daneben ermöglicht die oben angegebene Berechnungsart noch die Erfassung des magnetischen Gleichfelds.

Eine schematische Darstellung zur Veranschaulichung einer alternativen Anordnung von magnetfeldempfindlichen Sensoren hinsichtlich dreier Leiter, in denen ein Strom gemessen werden soll, ist in Fig. 3 dargestellt. Wiederum sind vier Sensoren S1 bis S4 bezüglich dreier Leiter L1 bis L3 derart angeordnet, daß jeweils zwei magnetfeldempfindliche Sensoren benachbart zu einem jeweiligen Leiter angeordnet sind. Jedoch sind in diesem Fall die Sensoren jeweils senkrecht verschoben bezüglich einer durch die Leiter gedachten Linie angeordnet, beispielsweise bezüglich der Leiter nach oben bzw. nach unten versetzt. Eine solche Anordnung ist beispielsweise ohne weiteres realisierbar, wenn die Sensoren Hall-Sensoren sind und mit den Leitern monolithisch auf einem Halbleitersubstrat gefertigt sind. Hier können die Leiterbahnen L1 bis L3, die in Fig. lediglich schematisch mit rundem Querschnitt dargestellt sind, beispielsweise Leiterbahnen sein, über denen eine dielektrische Schicht angeordnet ist, wobei auf dieser dielektrischen Schicht dann die magnetfeldempfindlichen Sensoren angeordnet sind. Die in Fig. 3 dargestellte Anordnung, bzw. eine Anordnung der Sensoren direkt zwischen den Leitern wird verwendet, wenn die Sensoren auf senkrecht auftreffende Magnetfelder empfindlich sind.

Eine Anordnung von Sensoren zu Leitern, wenn die Sensoren gegenüber parallel zur Oberfläche auftreffenden Magnetfeldern empfindlich sind, wie dies beispielsweise bei Feldplatten der Fall ist, ist in Fig. 4 dargestellt. Bei dieser Anordnung laufen die Feldlinien eines Magnetfelds, das durch Ströme durch die Leiter L1 bis L3 erzeugt wird, parallel zu den Hauptoberflächen der Sensoren S1 bis S4. Auch in diesem Fall sind zum Messen der Ströme durch n Leiter lediglich n+1 magnetfeldempfindliche Sensoren erforderlich.

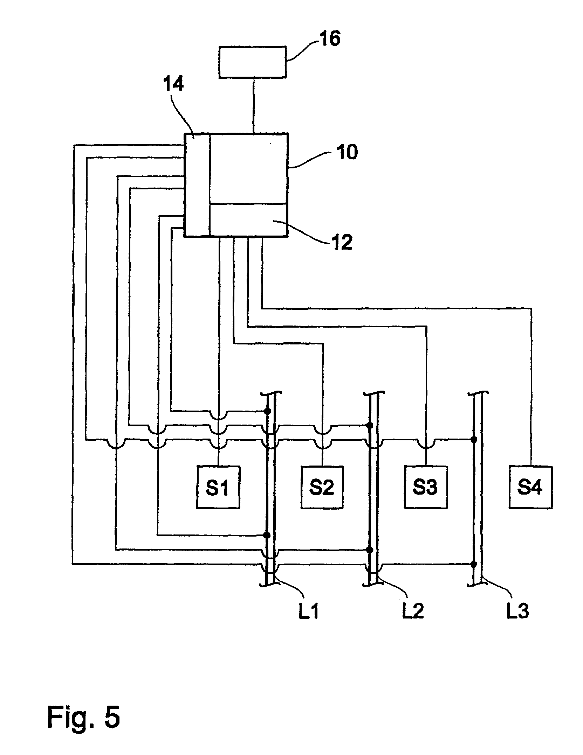

Eine schematische Übersichtsdarstellung einer erfindungsgemäßen Strommeßvorrichtung ist in Fig. 5 gezeigt. Wiederum ist die Anordnung der drei Leiter L1 bis L3 und der vier magnetfeldempfindlichen Sensoren S1 bis S4 zu erkennen. Die magnetfeldempfindlichen Sensoren S1 bis S4 sind jeweils mit einer Auswerteeinheit 10 verbunden. Spezieller sind die Sensoren S1 bis S4 mit einer Ausleseeinrichtung 12 der Auswerteeinheit verbunden. In der Auswerteeinheit 10 wird die oben beschriebene Berechnung des Stroms durch die jeweiligen Leiter L1 bis L3 durchgeführt. Die Auswerteeinheit 10 weist vorzugsweise ferner eine Kalibriereinrichtung 14 auf, mittels derer die oben beschriebenen Koeffizienten ermittelt werden. Dazu ist die Kalibriereinrichtung 14 in geeigneter Weise mit den jeweiligen Leitern L1 bis L3 verbunden, um einen bekannten Stromfluß durch dieselben bewirken zu können. Dies ist in Fig. 5 durch die schematisch dargestellten Leitungen zwischen der Kalibriereinheit 14 und den jeweiligen Leitern L1 bis L3 gezeigt. Ferner ist vorzugsweise eine Einrichtung zum Erzeugen eines bekannten Gleichmagnetfelds (nicht dargestellt) vorgesehen, um die Ermittlung der Koeffizienten $a_{g1}$ bis $a_{g4}$ zu ermöglichen. Alternativ können diese Koeffizienten jeweils den Wert 1 oder einen anderen vorgegebenen Wert erhalten. Die Auswerteeinheit 10 umfaßt ferner vorzugsweise einen Speicher 16, in dem die ermittelten Koeffizienten vorzugsweise in Matrixform abgelegt werden. Die Koeffizienten können entweder in der ermittelten Form abgelegt werden, wobei jedoch vorzugsweise aus den ermittelten Koeffizienten zunächst die Elemente der invertierten Matrix berechnet werden, die dann in dem Speicher 16 abgelegt werden. Es ist offensichtlich, daß der Speicher 16 in die Auswerteeinheit 10 integriert sein kann, obwohl er in Fig. 5 getrennt von derselben dargestellt ist.

Die vorliegende Erfindung schafft somit eine Strommeßvorrichtung bzw. ein Verfahren zum Strommessen, bei denen zum Messen des Stroms durch n Leiter lediglich n+1 magnetfeldempfindliche Sensoren benötigt werden. Obwohl in den Figuren lediglich nebeneinander angeordnete Leiter L1 bis L3 dargestellt sind, kann die vorliegende Erfindung auch auf Leiteranordnungen angewendet werden, bei denen Leiter senkrecht zueinander verlaufen, beispielsweise in einem Mehrschichtsubstrat, wobei wiederum jeweils nur n+1 magnetfeldempfindliche Sensoren erforderlich sind.

## Patentansprüche

1.  Strommeßvorrichtung zum Messen des Stroms durch einen oder mehrere Leiter einer Anordnung von n Leitern (L1 bis L3), mit $n \in \mathbb{N}$ und $n \geq 2$, mit folgenden Merkmalen:

    n+1 magnetfeldempfindlichen Sensoren (S1 bis S4), die derart angeordnet sind, daß jeweils zwei magnetfeldempfindliche Sensoren benachbart zu einem jeweiligen Leiter angeordnet sind;

    einer Einrichtung zum Auslesen (12) von Ausgangssignalen der magnetfeldempfindlichen Sensoren (S1 bis S4); und

    einer Einrichtung (10) zum Berechnen des Stroms durch einen oder mehrere der Leiter (L1 bis L3) auf der Grundlage der ausgelesenen Ausgangssignale und von Koeffizienten, die den Einfluß von Strömen durch jeden der n Leiter und eines magnetischen Gleichfelds auf das Ausgangssignal eines jeden der magnetfeldempfindlichen Sensoren (S1 bis S4) beschreiben.

2.  Strommeßvorrichtung nach Anspruch 1, bei der die magnetfeldempfindlichen Sensoren (S1 bis S4) derart angeordnet sind, daß jeder Leiter (L1 bis L3) zwischen zwei der magnetfeldempfindlichen Sensoren angeordnet ist.

3.  Strommeßvorrichtung nach Anspruch 1, bei der die magnetfeldempfindlichen Sensoren (S1 bis S4) senkrecht verschoben zu einer zwischen zwei Leitern gedachten Linie angeordnet sind.

4.  Strommeßvorrichtung nach einem der Ansprüche 1 bis 3, bei der die magnetfeldempfindlichen Sensoren (S1 bis S4) Hallsensoren sind.

5.  Strommeßvorrichtung nach Anspruch 4, bei der die Hallsensoren zusammen mit der Einrichtung (12) zum Auslesen und der Einrichtung (10) zum Berechnen monolithisch auf einem Halbleitersubstrat integriert sind.

6.  Strommeßvorrichtung nach einem der Ansprüche 1 bis 5, bei der die Koeffizienten in Matrixform in einer Speichereinrichtung (16) gespeichert sind.

7.  Strommeßvorrichtung nach Anspruch 6 in Rückbezug auf Anspruch 5, bei der die Speichereinrichtung (16) auf dem Halbleitersubstrat integriert ist.

8.  Verfahren zum Messen des Stroms durch einen oder mehrere Leiter einer Anordnung von n Leitern (L1 bis L3), mit $n \in \mathbb{N}$ und $n \geq 2$, mit folgenden Schritten:

Auslesen der Ausgangssignale von n+1 magnetfeldempfindlichen Sensoren (S1 bis S4), von denen jeweils zwei benachbart zu einem jeweiligen Leiter angeordnet sind;

Berechnen des Stroms durch einen oder mehrere der Leiter (L1 bis L3) auf der Grundlage der ausgelesenen Ausgangssignale und von Koeffizienten, die den Einfluß von Strömen durch jeden der n Leiter (L1 bis L3) und eines magnetischen Gleichfelds auf das Ausgangssignal eines jeden der magnetfeldempfindlichen Sensoren (S1 bis S4) beschreiben.

9. Verfahren nach Anspruch 8, das ferner den Schritt des Bestimmens der Koeffizienten auf der Grundlage des Ausgangssignals eines jeden der magnetfeldempfindlichen Sensoren (S1 bis S4), während nacheinander durch jeden der Leiter ein bekannter Stromfluß bewirkt wird, während durch die übrigen Leiter kein Strom fließt, und auf der Grundlage des Ausgangssignals eines jeden der magnetfeldempfindlichen Sensoren (S1 bis S4) während der Beaufschlagung mit einem bekannten Gleichmagnetfeld, wobei kein Strom durch die Leiter fließt, aufweist.

10. Verfahren nach Anspruch 9, das ferner den Schritt des Speicherns der Koeffizienten aufweist.

11. Verfahren nach einem der Ansprüche 8 bis 10, bei dem der Schritt des Berechnens das Durchführen einer linearen Verknüpfung der Ausgangssignale der magnetfeldempfindlichen Sensoren (S1 bis S4) mittels einer Matrixoperation umfaßt, wobei die Koeffizienten, die den Einfluß von Strömen durch jeden der n Leiter (L1 bis L3) und eines magnetischen Gleichfelds auf das Ausgangssignal eines jeden der magnetfeldempfindlichen Sensoren (S1 bis S4) beschreiben, als Matrixkoeffizienten verwendet werden.

**Claims**

1. A current measuring device for measuring a current through one or a plurality of conductors of an array of n conductors (L1 to L3), with $n \in \mathbb{N}$ and $n \geq 2$, comprising the following features:

n+1 magnetic-field-sensitive sensors (S1 to S4) which are arranged in such a way that two respective magnetic-field-sensitive sensors are arranged adjacent a respective conductor;

a unit (12) for reading out output signals of the magnetic-field-sensitive sensors (S1 to S4); and

a unit (10) for calculating the current through one or a plurality of conductors (L1 to L3) on the basis of the read output signals and on the basis of coefficients which describe the influence of currents flowing through each of the n conductors and of a constant magnetic field on the output signal of each of the magnetic-field-sensitive sensors (S1 to S4).

2. A current measuring device according to claim 1, wherein the magnetic-field-sensitive sensors (S1 to S4) are arranged such that each conductor (L1 to L3) is arranged between two of said magnetic-field-sensitive sensors.

3. A current measuring device according to claim 1, wherein the magnetic-field-sensitive sensors (S1 to S4) are arranged such that they are displaced perpendicularly with respect to an imaginary line extending between two conductors.

4. A current measuring device according to one of the claims 1 to 3, wherein the magnetic-field-sensitive sensors (S1 to S4) are Hall sensors.

5. A current measuring device according to claim 4, wherein the Hall sensors, together with the read-out unit (12) and the calculating unit (10), are monolithically integrated on a semiconductor substrate.

6. A current measuring device according to one of the claims 1 to 5, wherein the coefficients in the form of a matrix are stored in a memory means (16).

7. A current measuring device according to claim 6 referring back to claim 5, wherein the memory means (16) is integrated on the semiconductor substrate.

8. A method of measuring the current through one or a plurality of conductors of an array of n conductors (L1 to L3),

with $n \in \mathbb{N}$ and $n \geq 2$, comprising the following steps:

> reading out the output signals of n+1 magnetic-field-sensitive sensors (S1 to S4), two respective ones of said sensors being arranged adjacent a respective conductor;

> calculating the current through one or a plurality of the conductors (L1 to L3) on the basis of the read output signals and on the basis of coefficients which describe the influence of currents flowing through each of the n conductors (L1 to L3) and of a constant magnetic field on the output signal of each of the magnetic-field-sensitive sensors (S1 to S4).

9. A method according to claim 8, comprising in addition the step of determining the coefficients on the basis of the output signal of each of the magnetic-field-sensitive sensors (S1 to S4) while a known flow of current is successively caused through each of the conductors, whereas no current flows through the rest of the conductors, and on the basis of the output signal of each of the magnetic-field-sensitive sensors (S1 to S4) during application of a known constant magnetic field, while no current flows through the conductors.

10. A method according to claim 9, comprising in addition the step of storing the coefficients.

11. A method according to one of the claims 8 to 10, wherein the calculation step comprises the execution of a linear interconnection of the output signals of the magnetic-field-sensitive sensors (S1 to S4) by means of a matrix operation, the coefficients which describe the influence of currents flowing through each of the n conductors (L1 to L3) and of a constant magnetic field on the output signal of each of the magnetic-field-sensitive sensors (S1 to S4) being used as matrix coefficients.

**Revendications**

1. Dispositif de mesure du courant dans un ou plusieurs conducteurs d'un aménagement de n conducteurs (L1 à L3), avec $n \in N$ et $n \geq 2$, dispositif aux caractéristiques suivantes :

   - n+1 capteurs de champs magnétiques (S1 à S4) implantés de telle sorte qu'à proximité de chaque conducteur soient disposés deux capteurs de champs magnétiques
   - un dispositif de lecture (12) de signaux de sortie des capteurs de champs magnétiques (S1 à S4) ; et
   - un dispositif (10) de calcul du courant dans un ou plusieurs conducteurs (L1 à L3) sur la base desdits signaux de sortie et de coefficients décrivant l'influence des courants dans chacun des n conducteurs, ainsi que d'un champ magnétique continu sur le signal de sortie de chacun des capteurs de champs magnétiques (S1 à S4).

2. Dispositif de mesure de courant selon la revendication 1, dans lequel les capteurs de champs magnétiques (S1 à S4) sont disposés de telle sorte que chaque conducteur (L1 à L2) se situe entre deux capteurs de champs magnétiques.

3. Dispositif de mesure de courant selon la revendication 1 ou 2 dans lequel les capteurs de champs magnétiques (S1 à S4) sont décalés perpendiculairement par rapport à une ligne imaginaire entre deux conducteurs.

4. Dispositif de mesure de courant selon l'une des revendications 1 à 3, dans lequel les capteurs de champs magnétiques (S1 à S4) sont des capteurs à effet hall.

5. Dispositif de mesure de courant selon la revendication 4, dans lequel les capteurs à effet hall sont intégrés, avec le dispositif de lecteur (12) et le dispositif de calcul (10) de manière monolithique sur un substrat semi-conducteur.

6. Dispositif de mesure de courant selon l'une des revendications 1 à 5, dans lequel lesdits coefficients sont mémorisés sous forme de matrices dans une mémoire (16).

7. Dispositif de mesure de courant selon les revendications 5 et 6 dans lequel la mémoire (16) est intégrée au substrat semi-conducteur.

8. Procédé de mesure du courant passant par un ou plusieurs conducteurs d'un aménagement de n conducteurs (L1 à L3) avec $n \in N$ et $n \geq 2$, comportant les étapes suivantes :

- lecture des signaux de sortie des n+1 capteurs de champs magnétiques dont à chaque fois deux d'entre eux sont disposés à proximité d'un conducteur ;
- calcul du courant dans un ou plusieurs des conducteurs (L1 à L3) sur la base des signaux de sortie lus et de coefficients décrivant l'influence des courants dans chacun des n conducteurs (L1 à L3) et d'un champ magnétique continu sur le signal de sortie de chacun des capteurs de champs magnétiques (S1 à S4).

9. Procédé selon la revendication 8, consistant, par ailleurs, à déterminer lesdits coefficients, d'une part, sur la base du signal de sortie de chacun des capteurs de champs magnétiques (S1 à S4) en soumettant, successivement, chacun des conducteurs à un courant connu tout en maintenant dans les autres conducteurs un courant nul et, d'autre part, sur la base du signal de sortie de chacun des capteurs de champs magnétiques (S1 à S4) sous l'influence d'un champ magnétique continu connu en l'absence de courant dans les conducteurs.

10. Procédé selon la revendication 1 consistant à mémoriser les coefficients.

11. Procédé selon l'une des revendications 8 à 10 dans lequel l'étape de calcul comporte la réalisation d'une combinaison linéaire de signaux de sortie des capteurs de champs magnétiques (S1 à S4) au travers d'une opération matricielle, les coefficients, décrivant l'influence du courant dans chacun des n conducteurs (L1 à L4) et d'un champ magnétique continu sur le signal de sortie de chacun des capteurs de champs magnétiques (S1 à S4), étant utilisés comme coefficients de la matrice.

**Fig. 1**

**Fig. 2**

**Fig. 3**

**Fig. 4**

Fig. 5